# EUROPÄISCHE PATENTSCHRIFT

(11) **EP 0 872 573 B1**
(45) Veröffentlichungstag und Bekanntmachung des Hinweises auf die Patenterteilung: **05.12.2001**
(21) Anmeldenummer: 98105913.2
(22) Anmeldetag: 01.04.1998
(51) Int. Cl.: C23C 14/56, H01L 21/00, H01J 37/00

(54) **Vakuumbehandlungsvorrichtung zum Aufbringen dünner Schichten**
Vacuum processing apparatus for depositing thin layers
Dispositif de traitement sous vide de dépôt de couches minces

(30) Priorität: 12.04.1997 DE 19715245
(43) Veröffentlichungstag der Anmeldung: 21.10.1998
(73) Patentinhaber: Unaxis Trading AG, 9477 Trübbach (CH)
(72) Erfinder: Maidhof, Hans, 63773 Goldbach (DE); Schüssler, Hans, 66578 Schiffweiler (DE); Kunkel, Stefan, 63457 Hanau (DE); Beul, Johannes, 56479 Rehe (DE); Heinrich, Jürgen, D-63694 Limeshain (DE)

(56) Entgegenhaltungen:
- EP-A- 0 737 998

## Beschreibung

Die Erfindung betrifft eine Vakuumbehandlungsvorrichtung zum Aufbringen dünner Schichten auf Substrate mit mehreren, von einer ortsfesten ring- oder rahmenförmigen Seitenwand der Vakuumkammer gehaltenen, die Bearbeitungswerkzeuge enthaltenden Behandlungskammern, mit auf das Zentrum der Vakuumkammer ausgerichteten, in sich zueinander parallelen Ebenen erstreckenden Öffnungen.

Bekannt ist eine Vakuumbehandlungsanlage mit einer Hauptkammer bzw. Verteilerkammer (EP 0 555 764), innerhalb welcher die zu beschichtenden Substrate bzw. Werkstücke mittels eines Transportmechanismus zwischen mindestens zwei Bearbeitungskammern bzw. zwischen einer Schleusenkammer und mindestens einer Bearbeitungskammer gefördert werden, wobei ein Teil oder alle der Bearbeitungskammern mittels hydraulisch oder pneumatisch aktivierbarer Dichtungen gegenüber der Hauptkammer bzw. Verteilerkammer dicht trennbar sind, wobei die Anlage zylinderartig ausgebildet ist und mindestens eine Aufnahmekammer bzw. ein Behältnis für die Aufnahme der zu bearbeitenden Substrate entlang des Mantels einer kreis- bzw. zylinderförmigen Verteilerkammer angeordnet ist, welche in den jeweiligen Bearbeitungspositionen gegen die entsprechenden im Zylindermantel angeordneten Bearbeitungsstationen gerichtet sind, um die Bearbeitungs- bzw. Prozeßkammern zu bilden, welche Aufnahmekammern bzw. Behältnisse oder der Zylindermantel um die Zylindermittelachse rotierbar angeordnet sind.

Bekannt ist auch eine Vorrichtung zum Aufbringen von Schichten auf Trägern unter Vakuum (DE 28 48 480), insbesondere für das abwechselnde Aufbringen von Metallschichten und von Glimmpolymerisationsschichten auf Träger bei der Herstellung von elektrischen Schichtkondensatoren, welche zumindest zwei Vakuumkammern aufweist, die durch Vakuumschleusen voneinander getrennt sind und bei denen in der ersten Vakuumkammer im Betrieb ein kleinerer Restdruck besteht als in der zweiten Kammer oder in den übrigen Kammern, welche eine Transporteinrichtung besitzt, die die zu beschichtenden Träger durch je eine gesonderte Vakuumschleuse von der ersten Vakuumkammer in die zweite Vakuumkammer und wieder in die erste Vakuumkammer oder in eine dritte Vakuumkammer transportieren kann, welche in den Vakuumkammern Einrichtungen zum Aufbringen von Schichten auf die auf der Transporteinrichtung befindlichen Träger enthält und bei welcher die Vakuumschleusen jeweils mehrere Backen, die einer Oberfläche bzw. Oberflächen der Transporteinrichtung unmittelbar gegenüberliegen und zu dieser bzw. diesen nur einen schmalen Spalt freilassen, und jeweils zwischen zwei Backen en Absaugrohr zur Absaugung des Restgases aufweisen, wobei die Transporteinrichtung nur in einer Richtung bewegbar ist und die in Bewegungsrichtung der Transporteinrichtung von der ersten Vakuumkammer liegende Vakuumschleuse längere Diffusionswege aufweist als die in Bewegungsrichtung der Transporteinrichtung hinter der ersten Vakuumkammer liegende Vakuumschleuse.

Der vorliegenden Erfindung liegt die Aufgabe zugrunde, eine Vorrichtung des in Frage stehenden Typs zu schaffen, bei der die Substrate in einzelnen Behältnissen angeordnet und darüber hinaus so gestaltet sein sollen, daß Substrate verschiedener Größe und insbesondere extrem verwickelter Konfiguration bearbeitet werden können. Darüber hinaus sollen mehrere verschiedenartige Behandlungen der Substrate durchführbar sein, ohne daß die Vakuumkammer belüftet und eine Übergabe der Substrate von Substratträger zu Substratträger erfolgen muß.

Diese Aufgabe wird erfindungsgemäß dadurch gelöst, daß mehrere ortsfeste, von der ring- oder rahmenförmigen Seitenwand der Vakuumkammer gehaltene, die Behandlungswerkzeuge aufweisende Behandlungskammern mit peripher nach innen auf das Zentrum der Vakuumkammer ausgerichtete, in sich zueinander parallelen Ebenen erstreckende Behandlungskammeröffnungen zum Ein- und Ausschleusen der Substrate vorgesehen sind, sowie eine sich parallel zu den Öffnungsebenen erstreckenden, im Vakuumkammerdekkel und/oder in der Vakuumkammerbodenplatte der Vakuumkammer gelagerten Welle oder Schraubenspindel mit von dieser gehaltenen und bewegten Platten zum Verschließen der Behandlungskammeröffnungen und mit Operatoren zum Verfahren der Verschlußplatten von einer radial inneren Öffnungs- zu einer radial äußeren Schließposition, wobei die mit der Welle oder der Schraubenspindel zusammenwirkenden Operatoren als Hebeltriebe oder teleskopierbare Ausleger ausgebildet sind und die Verschlußplatten auf ihren jeweils den Behandlungskammern zugewandten Seitenflächen Substrathalter oder -greifer aufweisen.

Weitere Merkmale und Einzelheiten sind in den Unteransprüchen näher beschrieben und gekennzeichnet.

Die Erfindung läßt die verschiedensten Ausführungsmöglichkeiten zu; drei davon sind in den anhängenden Zeichnungen rein schematisch näher dargestellt, und zwar zeigen:
- Fig. 1: den Schnitt quer durch eine Vorrichtung mit vier Verschlußplatten, die mit Hilfe einer Lenkergeradführung durch die Drehbewegung einer Welle gegen die jeweils ihnen gegenüberliegenden Schleusenöffnungen verfahrbar sind, wozu die Verschlußplatten in Führungsnuten der drehbaren Bodenplatte gleiten,
- Fig. 2: den Schnitt quer durch eine andere Ausführungsform der Vorrichtung, bei der die Verschlußplatten mit Hilfe von teleskopierbaren Auslegern bewegbar sind, wobei die Verschlußplatten an ihren den Behandlungskammern zugekehrten Seiten mit Armen zur Halterung der Substrate versehen sind und
- Fig. 3: den Schnitt längs durch eine weitere Ausführungsform der Vorrichtung, bei der die Verschlußplatten mit Hilfe von Hebeln radial bewegbar sind, die an der Schraubenmutter einer Schraubenspindel angelenkt sind.

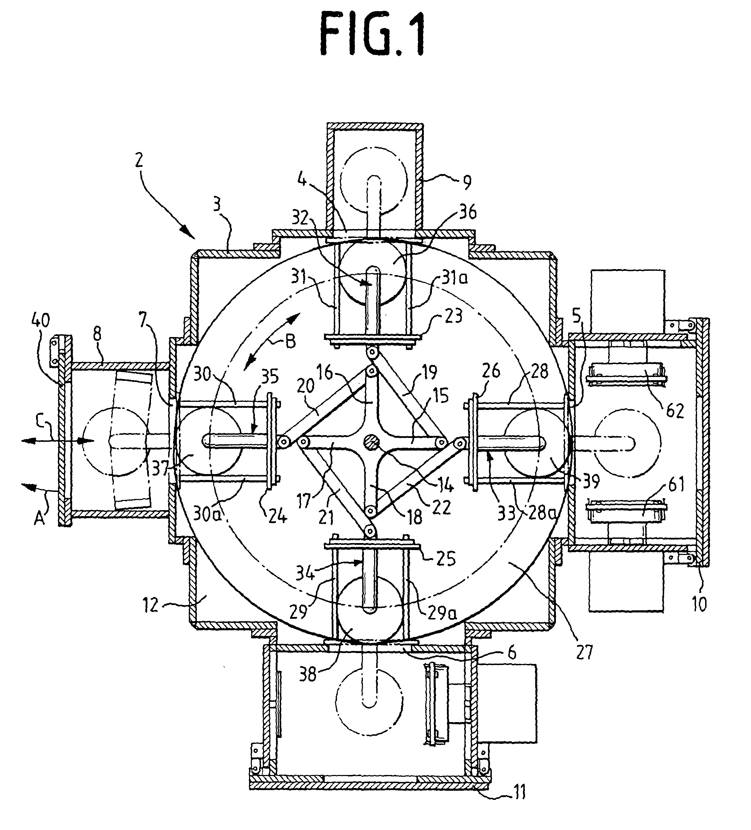

Wie Fig. 1 zeigt, besteht die Vakuumbehandlungsvorrichtung im wesentlichen aus einem rahmenförmigen Seitenteil 3 mit insgesamt vier Öffnungen 4 bis 7, den vier kastenförmigen Behandlungskammern, einer das Seitenteil 3 nach unten zu verschließenden Vakuumkammerbodenplatte 12, einem nicht dargestellten, das Seitenteil 3 nach oben zu verschließenden Vakuumkammerdeckel, der in der Bodenplatte 12 und dem Kammerdeckel drehbar und lotrecht gelagerten Welle 14 mit an dieser befestigten, sich sternförmig horizontal erstreckenden Armen 15 bis 18, den mit den Armen 15 bis 18 gelenkig verbundenen Zug-/Druckstreben 19 bis 22, den den jeweiligen Behandlungskammern 8 bis 11 zugeordneten, mit den Enden der Streben 19 bis 22 gelenkig verbundenen Verschlußplatten 23 bis 26 mit den an ihnen befestigten Substratträgern, einer mit der Welle 14 drehfest verbundenen Führungsplatte 27 mit auf dieser befestigten Schienenpaaren 28 bis 31 zur Halterung und Führung der Verschlußplatten 23 bis 26 und den in den vier Behandlungskammern 8 bis 11 angeordneten - und nicht näher dargestellten - Beschichtungswerkzeugen, wie z. B. Glimm- und Sputterkathoden 41,42.

Zur Inbetriebnahme der in Fig. 1 dargestellten Vorrichtung werden die an den Verschlußplatten 23 bis 26 fest angeordneten Substratträger 32 bis 35 mit Substraten 36 bis 39 bestückt, was beispielsweise dadurch ermöglicht wird, daß der Deckel 40 der Behandlungskammer 8 in Pfeilrichtung A geöffnet wird und die Substrate durch die Behandlungskammer 8 hindurchgeführt und auf den jeweils vor der Öffnung 7 befindlichen Substratträger aufgehängt werden, wozu die Führungsplatte 27 zusammen mit der Welle 14 und den an dieser angelenkten Verschlußplatten 2 bis 26 drehbar (Pfeilrichtung B) ist und die Verschlußplatten 23 bis 26 auch - bei stillstehender Führungsplatte 27, aber drehbarer Welle 14 - in radialer Richtung auf den Schienenpaaren verschiebbar sind.

Nachdem die Substratträger 32 bis 35 mit Substraten 36 bis 39 bestückt worden sind und der Deckel 40 geschlossen wurde, können die Hauptkammer 2 und die mit ihr verbundenen Behandlungskammern 8 bis 11 evakuiert werden. Wird die Welle 14 nun bei stillstehender Führungsplatte 27 um etwa 90° gedreht - entgegen dem Uhrzeigersinn -, dann bewegen sich alle vier Verschlußplatten 23 bis 26 radial nach außen zu und die Öffnungen 4 bis 7 werden von diesen verschlossen. Durch Einschalten der Bearbeitungswerkzeuge, z. B. der Kathoden 41,42, erfolgt nun die Behandlung der Substrate. Wenn in den Behandlungskammern nun verschiedenartige Werkzeuge angeordnet sind, kann jedes Substrat der Reihe nach in jede der vier Behandlungskammern 8 bis 11 gefördert und dort in der gewünschten Reihenfolge behandelt werden. Die Entnahme der Substrate 36 bis 39 kann nach erfolgter Behandlung auf dem gleichen Wege geschehen, wie auch die Bestückung erfolgte.

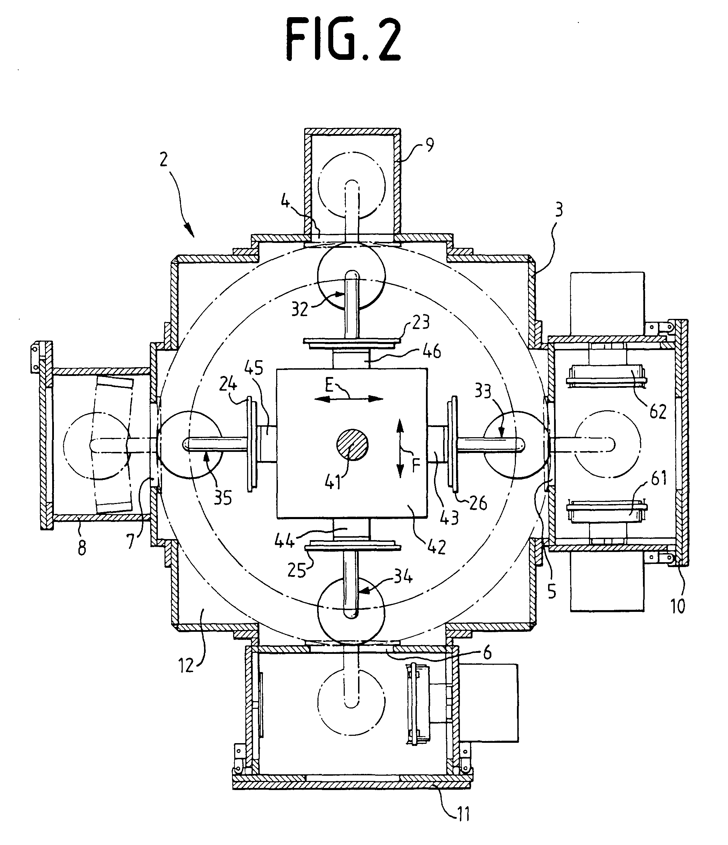

Bei der Ausführungsform der Vakuumbehandlungsvorrichtung nach Fig. 2 ist an Stelle einer Welle 14 mit Armen 15 bis 18 mit an diesen angelenkten Schub-/Druckstreben 19 bis 22 ein mit der Welle 41 drehbar auf der Bodenplatte 12 gelagertes Gehäuse 42 mit vier in diesem gehaltenen und geführten Auslegern 43 bis 46 vorgesehen. Diese Ausleger 43 bis 46 sind gegenüber dem Gehäuse 42 in Richtung der Pfeile E bzw. F teleskopierbar, so daß die an den freien Enden der Ausleger 43 bis 46 befestigten Verschlußplatten 23 bis 26 vor die Öffnungen 4 bis 7 oder in die in der Zeichnung dargestellte Ausgangsstellung bewegbar sind.

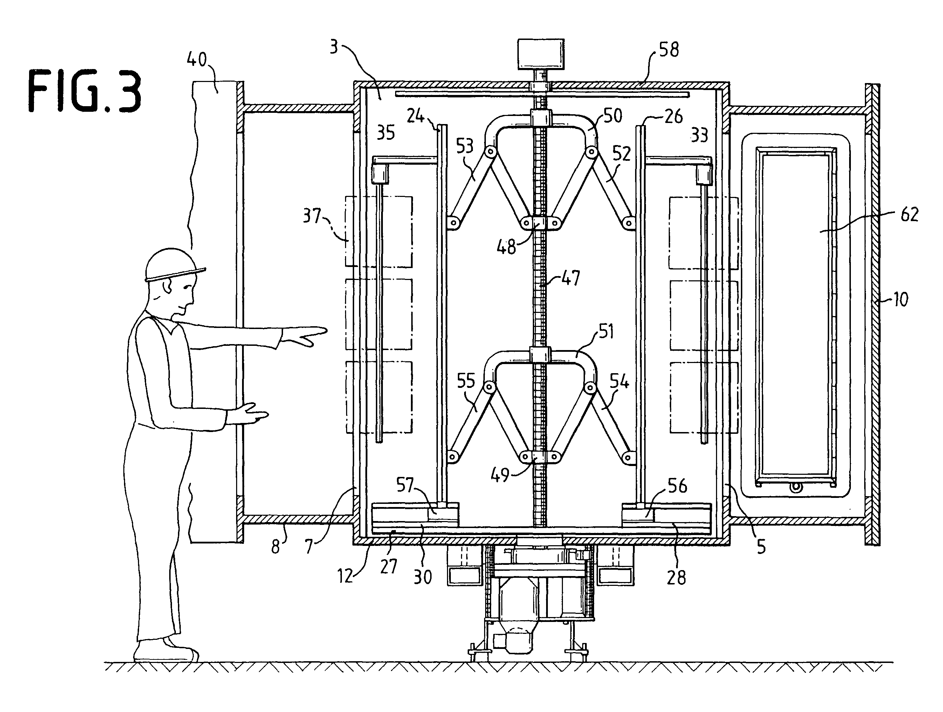

Die Ausführungsform der Vakuumbehandlungsvorrichtung nach Fig. 3 weist an Stelle einer Welle 14 eine Schraubenspindel 47 auf, die mit Schraubenmuttern 48,49 zusammenwirkt, die Teile von auf der Schraubenspindel geführten Jochen 50,51 sind. Infolge von Drehbewegungen der Spindel 47 verschieben die mit den Jochen 50,51 gelenkig verbundenen Zug-/Druckstreben 52,53 bzw. 54,55 die Verschlußplatten 24,26 - je nach Drehrichtung - radial nach außen oder aber radial nach innen, wobei die Verschlußplatten 24,26 in den Schienenpaaren 28,28a bzw. 30,30a geführt werden, in die die Verschlußplatten 24,26 mit ihren Gleitschuhen 56,57 eingreifen.

Während die Schienenpaare 28,28a,...,31,31a sicher stellen, daß die ihnen jeweils zugeordneten Verschlußplatten 23 bis 26 - bezogen auf die Gehäusemittelpunktsachse bzw. auf die Welle 14,41 oder Schraubenspindel 47 - sich nur in radialer Richtung bewegen können, tragen die Zug-/Druckstreben 19 bis 22 oder Ausleger 42 bis 45 oder Hebelgetriebe 52 bis 55 dafür Sorge, daß bei einer Drehbewegung der Welle 14,41 oder Schraubenspindel 47 gegenüber der Führungsplatte 27 eine solche Bewegung aller Verschlußplatten nur gleichzeitig und in gleicher Richtung erfolgen kann.

Eine synchrone Drehbewegung von Führungsplatte 27 und welle 14,41 bzw. Schraubenspindel 47 hat zur Folge, daß alle Verschlußplatten 23 bis 26 gleichzeitig zusammen mit den von ihnen gehaltenen Substraten 36 bis 39 in Pfeilrichtung, d. h. von der einen zur nächsten Behandlungsstation bewegt werden - vorausgesetzt, die Verschlußplatten 23 bis 26 sind zuvor in ihre Ausgangsposition bewegt worden-.

### Bezugszeichenliste

- 2: Hauptkammer
- 3: rahmenförmiges Seitenteil
- 4: Öffnung, Behandlungskammeröffnung
- 5: Öffnung, Behandlungskammeröffnung
- 6: Öffnung, Behandlungskammeröffnung
- 7: Öffnung, Behandlungskammeröffnung
- 8: Behandlungskammer
- 9: Behandlungskammer
- 10: Behandlungskammer
- 11: Behandlungskammer
- 12: Bodenplatte
- 14: Welle
- 15: Arm
- 16: Arm
- 17: Arm
- 18: Arm
- 19: Zug-/Druckstrebe
- 20: Zug-/Druckstrebe
- 21: Zug-/Druckstrebe
- 22: Zug-/Druckstrebe
- 23: Verschlußplatte
- 24: Verschlußplatte
- 25: Verschlußplatte
- 26: Verschlußplatte
- 27: Führungsplatte
- 28,28a: Schienenpaar
- 29,29a: Schienenpaar
- 30,30a: Schienenpaar
- 31,31a: Schienenpaar
- 32: Substratträger
- 33: Substratträger
- 34: Substratträger
- 35: Substratträger
- 36: Substrat
- 37: Substrat
- 38: Substrat
- 39: Substrat
- 40: Deckel
- 41: Welle
- 42: Gehäuse
- 43: Ausleger
- 44: Ausleger
- 45: Ausleger
- 45: Ausleger
- 47: Schraubenspindel
- 48: Schraubenmutter
- 49: Schraubenmutter
- 50: Joch
- 51: Joch
- 52: Zug-/Druckstrebe
- 53: Zug-/Druckstrebe
- 54: Zug-/Druckstrebe
- 55: Zug-/Druckstrebe
- 56: Gleitschuh
- 57: Gleitschuh
- 58: Kammerdeckel

* I believe this is a typographical error in the German and should read "27" - Translator

## Patentansprüche

1. Vakuumbehandlungsvorrichtung zum Aufbringen dünner Schichten auf Substrate (36 bis 39), mit mehreren ortsfesten, von der ring- oder rahmenförmigen Seitenwand (3) der Vakuumkammer (2) gehaltenen, die Behandlungswerkzeuge (41, 42) aufweisenden Behandlungskammern (8 bis 11) mit peripher nach innen auf das Zentrum der Vakuumkammer (2) ausgerichteten, in sich zueinander parallelen Ebenen erstrekkenden Behandlungskammeröffnungen (4 bis 7) zum Ein- und Ausschleusen der Substrate (36 bis 39) und mit einer sich parallel zu den Öffnungsebenen erstreckenden, im Vakuumkammerdeckel (58) und/oder in der Vakuumkammerbodenplatte (12) der Vakuumkammer (2) gelagerten Welle (14,41) oder Schraubenspindel (47) mit von dieser gehaltenen und bewegten Platten (23 bis 26) zum Verschließen der Behandlungskammeröffnungen (4 bis 7) und mit Operatoren (19 bis 22; 43 bis 46; 52 bis 55) zum Verfahren der Verschlußplatten (23 bis 26) von einer radial inneren Öffnungs- zu einer radial äußeren Schließposition, wobei die mit der Welle (14,41) oder der Schraubenspindel (47) zusammenwirkenden Operatoren als Hebeltriebe (19 bis 22; 52 bis 55) oder teleskopierbare Ausleger (43 bis 46) ausgebildet sind und die Verschlußplatten (23 bis 26) auf ihren jeweils den Behandlungskammern (8 bis 11) zugewandten Seitenflächen Substrathalter oder -greifer (32 bis 35) aufweisen.

2. Vakuumbehandlungsvorrichtung nach Anspruch 1, **dadurch gekennzeichnet, daß** die im Vakuumkammerdeckel (58) und/oder in der Vakuumkammerbodenplatte (12) gelagerte Welle (14) eine der Anzahl der Behandlungskammern (8 bis 11) entsprechende Zahl von sich von der Welle (14) aus radial erstreckenden, drehfest mit dieser verbundenen Armen (15 bis 18) aufweist, deren radial äußere Enden jeweils über ein Gelenklager mit einem zweiten Hebel oder einer Druck-/Zugstrebe (19 bis 22) verbunden sind, deren freie Enden jeweils gelenkig mit den Verschlußplatten (23 bis 26) verbunden sind, die in Geradeführungen, beispielsweise in Kulissen oder Schienenpaaren (28,28a bis 31,31a) gleiten, die jeweils nur eine Bewegung der Verschlußplatten rechtwinklig zur entsprechenden Öffnungsebene gestatten und an der Bodenplatte (12) und/oder dem Kammerdekkel (58) vorgesehen sind.

3. Vakuumbehandlungsvorrichtung nach Anspruch 1, **dadurch gekennzeichnet, daß** die im Vakuumkammerdeckel (58) und/oder in der Vakuumkammerbodenplatte (12) gelagerte, motorisch antreibbare Welle als Schraubenspindel (47) ausgebildet ist, wobei mit der Schraubenspindel (47) ein oder mehrere Schraubenmuttern (48,49) zusammenwirken, an die jeweils Hebel oder Druck-/Zugstreben (52 bis 55) angelenkt sind, deren freie Enden jeweils gelenkig mit den Verschlußplatten (23 bis 26) verbunden sind, wobei die Verschlußplatten (23 bis 26) in Kulissen oder Schienenpaaren (28,28a bis 31,31a) gehalten und geführt sind, die sich radial auf einer zur Bodenplatte (12) parallelen Führungsplatte (27) erstrecken und jeweils nur eine Bewegung der Verschlußplatten (23 bis 26) rechtwinklig zur jeweiligen Öffnungsebene gestatten.

4. Vakuumbehandlungsvorrichtung nach Anspruch 1, **dadurch gekennzeichnet, daß** die im Vakuumkammerdeckel (58) und/oder in der Vakuumkammerbodenplatte (12) gelagerte, motorisch antreibbare Welle (41) mit einer der Anzahl der Behandlungskammern (8 bis 11) entsprechenden Zahl von Auslegern (43 bis 46) verbunden ist, die jeweils in radialer Richtung auf die Behandlungskammeröffnungen (4 bis 7) zu teleskopierbar sind, wobei die freien Enden der Ausleger (43 bis 46)jeweils fest mit den Verschlußplatten (23 bis 26) verbunden sind, und wobei die Verschlußplatten (23 bis 26) auf ihren den Behandlungskammeröffnungen (4 bis 7) zugekehrten Seitenflächen jeweils mit Operatoren versehen sind, bestehend jeweils aus einem an der Verschlußplatte (23 bis 27) fest angeordneten, sich etwa horizontal in Richtung auf die jeweilige Behandlungskammeröffnung (4 bis 7) zu erstreckenden ersten Arm (32 bis 35) mit einem an dessen freiem Ende angelenkten zweiten Arm, dessen freies Ende mit einem Substratträger oder Substratgreifer (32 bis 35) versehen ist.

## Claims

1. Vacuum treatment device for depositing thin coatings on substrates (36 to 39), with several stationary treatment chambers (8 to 11) held by the annular or frame-like side wall (3) of the vacuum chamber (2) and holding the treatment tools (41, 42), with treatment chamber openings (4 to 7) extending in parallel planes aligned peripherally inwards towards the centre of the vacuum chamber (2) for inwards and outwards transfer of the substrate (36 to 39) via a lock, and with a shaft (14, 41) or screw spindle (47) extending parallel to the plane of the openings, mounted in the vacuum chamber lid (58) and/or in the vacuum chamber bottom plate (12) of the vacuum chamber (2), with plates (23 to 26) held and moved by the shaft or spindle for closing the treatment chamber openings (4 to 7), and with actuators (19 to 22; 43 to 46; 52 to 55) for moving the closing plates (23 to 26) from a radially inner opening position to a radially outer closing position, wherein the actuators working in conjunction with the shaft (14, 41) or the screw spindle (47) are in the form of lever pinions (19 to 22; 52 to 55) or telescopic extension arms (43 to 46) and the closing plates (23 to 26) have substrate holders or grippers (32 to 35) on their respective sides facing the treatment chambers (8 to 11).

2. Vacuum treatment device according to claim 1, **characterized in that** the shaft (14) mounted in the vacuum chamber lid (58) and/or in the vacuum chamber bottom plate (12) has a number of arms (15 to 18) corresponding to the number of treatment chambers (8 to 11), extending radially from the shaft (14) and connected to the latter so as to be incapable of turning, the radial outer ends of which are each connected via a pivot bearing to a second lever or push/pull strut (19 to 22), the free ends of which are each hinged to the closing plates (23 to 26) which slide in straight guides, for example slotted links or pairs of rails (28, 28a to 31, 31a) which respectively allow movement of the sealing plates only at right-angles to the corresponding opening plane and are provided at the bottom plate (12) and/or the chamber lid (58).

3. Vacuum treatment device according to claim 1, **characterized in that** the motor-driven shaft mounted in the vacuum chamber lid (58) and/or the vacuum chamber bottom plate (12) is in the form of a screw spindle (47), wherein working in conjunction with the screw spindle (47) are one or more screw nuts (48, 49) to which are hinged respectively levers or push/pull struts (52 to 55), the free ends of which are each hinged to the closing plates (23 to 26), wherein the closing plates (23 to 26) are held and guided in slotted links or pairs of rails (28, 28a to 31, 31a) which extend radially on a guide plate (27) parallel to the bottom plate (12) and respectively allow movement of the closing plates (23 to 26) only at right-angles to the respective opening plane.

4. Vacuum treatment device according to claim 1, **characterized in that** the motor-driven shaft (41) mounted in the vacuum chamber lid (58) and/or the vacuum chamber bottom plate (12) is connected to a number, corresponding to the number of treatment chambers (8 to 11), of extension arms (43 to 46) each capable of telescoping radially towards the treatment chamber openings (4 to 7), wherein the free ends of the extension arms (43 to 46) are each rigidly connected to the closing plates (23 to 26), and wherein the closing plates (23 to 26) are each provided, on their side surfaces facing the treatment chamber openings (4 to 7), with actuators each comprising a first arm (32 to 35) fixed securely to the closing plate (23 to 27*) to extend roughly horizontally towards the respective treatment chamber opening (4 to 7), together with a second arm hinged to the free end of the first arm and with a substrate holder or gripper (32 to 35) provided at its own free end.

## Revendications

1. Dispositif de traitement sous vide qui est destiné au dépôt de couches minces sur des substrats (36 à 39) et qui comporte plusieurs chambres de traitement (8 à 11) fixes qui sont portées par la paroi latérale (3) en forme d'anneau ou de cadre de la chambre à vide (2) et qui comprennent les outils de traitement (41, 42) et des ouvertures de chambre de traitement (4 à 7) qui sont disposées à la périphérie et dirigées vers l'intérieur vers le centre de la chambre à vide (2) et qui s'étendent dans des plans parallèles les uns aux autres pour l'éclusage au dedans et au dehors des substrats (36 à 39), et un arbre (14, 41) ou une tige filetée (47) qui s'étend parallèlement aux plans des ouvertures, qui est monté sur palier dans le couvercle de la chambre à vide (58) et/ou dans la plaque de fond de la chambre à vide (12) et qui comporte des plaques (23 à 26) maintenues et déplacées par l'arbre ou la tige filetée et servant à la fermeture des ouvertures de la chambre de traitement (4 à 7)) et des actionneurs (19 à 22 ; 43 à 46 ; 52 à 55) pour faire passer les plaques de fermeture (23 à 26) d'une position radiale intérieure d'ouverture à une position radiale extérieure de fermeture, dispositif dans lequel les actionneurs coopérant avec l'axe (14, 41) ou la tige filetée (47) sont réalisés sous la forme de mécanismes à levier (19 à 22 ; 52 à 55) ou de bras télescopiques (43 à 46) et les plaques de fermeture (23 à 26) comportent, sur leurs faces latérales orientées, à chaque fois, vers les chambres de traitement (8 à 11), des supports ou des dispositifs de préhension de substrat (32 à 35).

2. Dispositif de traitement sous vide selon la revendication 1, **caractérisé en ce que** l'arbre (14) monté sur palier dans le couvercle de la chambre à vide (58) et/ou dans la plaque de fond de la chambre à vide (12) comporte un nombre correspondant au nombre des chambres de traitement (8 à 11) de bras (15 à 18) qui s'étendent radialement, qui sont reliés sans possibilité de rotation avec l'arbre (14) et dont les extrémités radiales extérieures sont reliées, à chaque fois, par l'intermédiaire d'une articulation à rotule, à un deuxième levier ou à une jambe de poussée ou de tirage (19 à 22) dont l'extrémité libre est, à chaque fois, reliée avec articulation avec la plaque de fermeture (23 à 26) qui coulisse dans des guidages rectilignes, par exemple dans des coulisses ou des paires de rails (28, 28a à 31, 31a) qui, à chaque fois, ne permettent qu'un mouvement dans une direction perpendiculaire au plan de l'ouverture correspondant pour les plaques de fermeture et sont prévus sur la plaque de fond (12) et/ou le couvercle de la chambre (58).

3. Dispositif de traitement sous vide selon la revendication 1, **caractérisé en ce que** l'arbre qui est monté sur palier dans le couvercle de la chambre à vide (58) et/ou dans la plaque de fond de la chambre à vide (12) et qui peut être entraîné par un moteur est réalisé sous la forme d'une tige filetée (47), dans lequel un ou plusieurs écrous (48, 49) coopèrent avec la tige filetée (47), écrous (48, 49) sur lesquels, à chaque fois, sont articulés des leviers ou jambes de poussée ou de tirage (52 à 55) dont les extrémités libres sont, à chaque fois, reliées à articulation aux plaques de fermeture (23 à 26) et dans lequel les plaques de fermeture (23 à 26) sont maintenues et guidées dans des coulisses ou des paires de rails (28, 28a à 31, 31a) qui s'étendent radialement sur une plaque de guidage (27) parallèle à la plaque de fond (12) et, à chaque fois, ne permettent qu'un mouvement dans une direction perpendiculaire au plan de l'ouverture correspondant pour les plaques de fermeture (23 à 26).

4. Dispositif de traitement sous vide selon la revendication 1, **caractérisé en ce que** l'arbre qui est monté sur palier dans le couvercle de la chambre à vide (58) et/ou dans la plaque de fond de la chambre à vide (12) et qui peut être entraîné par un moteur est relié à un nombre correspondant au nombre des chambres de traitement (8 à 11) de bras (43 à 46) qui, à chaque fois, sont montés de manière télescopique dans la direction radiale vers les ouvertures de la chambre de traitement (4 à 7)), les extrémités libres des bras (43 à 46) étant, à chaque fois, reliés de manière fixe aux plaques de fermeture (23 à 26) et les plaques de fermeture (23 à 26) étant munies, sur leurs faces latérales dirigées vers les ouvertures de la chambre de traitement (4 à 7)) d'actionneurs constitués, à chaque fois, d'un premier bras (32 à 35) disposé de manière fixe, s'étendant sensiblement horizontalement dans la direction de l'ouverture correspondante de la chambre de traitement (4 à 7) et comportant un deuxième bras qui est articulé à son extrémité libre et dont l'extrémité libre est munie d'un support ou dispositif de préhension de substrat (32 à 35).
